Europäisches Patentamt

European Patent Office

Office européen des brevets

(11) Publication number: **0 436 790 A2**

## (12) EUROPEAN PATENT APPLICATION

(21) Application number: 90120776.1

(22) Date of filing: **30.10.90**

(51) Int. Cl.⁵: **G06F 15/60**

A request for addition of a missing page of the description has been filed pursuant to Rule 88 EPC. A decision on the request will be taken during the proceedings before the Examining Division (Guidelines for Examination in the EPO, A-V, 2.2).

(30) Priority: **08.11.89 US 433621**

(43) Date of publication of application:
**17.07.91 Bulletin 91/29**

(84) Designated Contracting States:
**DE FR GB**

(71) Applicant: **International Business Machines Corporation**
**Old Orchard Road**
**Armonk, N.Y. 10504(US)**

(72) Inventor: **Rajan, Vadakkedathu Thomas**
**223 Schrade Road, Apt. 1A**
**Briarcliff Manor, New York 10510(US)**
Inventor: **Silkowski, Richard Andrew**
**25 Anthony Drive, Apt. 207**
**Poughkeepsie, New York 12601(US)**

(74) Representative: **Blutke, Klaus, Dipl.-Ing.**
**IBM Deutschland GmbH Intellectual Property**
**Dept. Schönaicher Strasse 220**
**W-7030 Böblingen(DE)**

(54) **Multi-dimensional tree structure for the spatial sorting of geometric objects.**

(57) A computer program controlled method of processing geometric objects constructs a binary tree data structure 10 associated with bounding boxes of geometric objects. For each bound of a bounding box there is found a median (X) of all corresponding bounds, such as left sides associated with the bounding boxes. Next, all of the bounding boxes having a minimum bounding value less than X are placed on a left sub-tree 12 of the tree. All of the bounding boxes having a minimum bounding value greater than X are placed on a right sub-tree 14 of the tree. At the root are placed values that represent the maximum of that dimension's values in the left sub-tree and the minimum of that dimension's values in the right sub-tree. Boxes assigned to the left sub-tree and to the right sub-tree are similarly processed using a next bound such as the right sides. Searching the binary tree data structure in response to a query interval or box determines all of the boxes overlapping the Q box by comparing a lesser Q box bound with the left sub-tree's maximum value and by comparing a larger Q box bound with the right sub-tree's minimum value. The comparison generates information specifying if further search is carried out on the left sub-tree, the right sub-tree or on both sub-trees. Steps of the method are accomplished a plurality of times with successive bounds and recycling as required until the leaves of the tree are reached.

FIG. 4

EP 0 436 790 A2

## MULTI-DIMENSIONAL TREE STRUCTURE FOR THE SPATIAL SORTING OF GEOMETRIC OBJECTS

This invention relates generally to computer program controlled methods for modelling and displaying geometric objects and, in particular, to a method for preprocessing bounding boxes of geometric objects to more efficiently determine their overlap.

This method may be employed by, for example, hidden line removal and ray tracing processes. The method provides for an arbitrary set of multidimensional boxes to be sorted such that all boxes that touch or overlap a specified box can be rapidly identified. The method includes a step of constructing a binary tree data structure, the data structure being amenable to being rapidly and efficiently searched to determine overlaps between bounding boxes.

Geometric algorithms such as hidden line removal algorithms or merge algorithms typically require the determination cf intersections between geometric objects such as edges, faces, or solids. However, the processing costs of determining such intersections is high. As a result modellers often build two dimensional (2-d) or three dimensional (3-d) bounding boxes to enclose the objects of interest. Subsequently the bounding boxes are tested for overlap. A problem develops as models become larger, however, in that the comparison of these bounding boxes becomes a dominant and time consuming step of the algorithm.

As a result, a need exists for an efficient method for preprocessing such bounding boxes such that their overlap may be determined more efficiently, thus leading to a significant increase in the efficiency of those algorithms that require the determination of intersections between geometric objects.

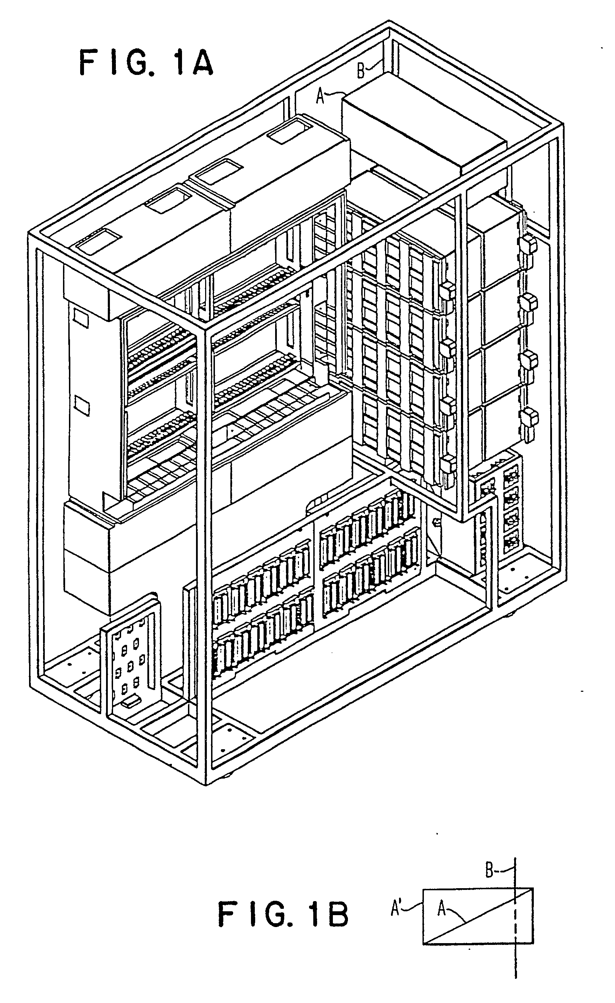

For example, a set of small to medium sized objects having from approximately 500 edges to approximately 50,000 edges were modeled by a 3-d solid modelling program known as a Geometric Design Processor (GDP). Aspects of GDP are described in a journal article entitled "Solid modeling for production design", R.N. Wolfe et al., IBM J. Res. Develop., Vol. 31 No. 3 5/87, at pages 277-295 and in a journal article entitled "A Geometric Modeling System for Automated Mechanical Assembly", M.A. Wesley et al., IBM J. Res. Develop., Vol. 24 No. 1, 1/80, at pages 64-74. Fig. 1A illustrates an output from GDP when employed to model a portion of a computer chassis. The output illustrated is displayed in hidden line mode. As can be seen, the displayed object is comprised of a large number of object edges. Fig. 1B shows in greater detail the edges designated A and B in Fig. 1A. If horizontal and vertical screen coordinates are used, the edge A has a bounding box $A'$ associated therewith. The edge B also has a bounding box but the bounding box has a width of zero. The bounding box associated with B intersects both the bounding box $A'$ and also the edge A. A hidden line removal algorithm utilizes such information in determining whether a portion of B is hidden by a surface or face with which the edge A is associated.

It can be shown that a hidden line removal algorithm operating to test the overlap of every pair of edges in the model would require $O(n^2)$ operations to run, where n is the number of edges. If unsorted bounding boxes are employed instead to reduce the required time for the edge-edge comparison, the efficiency of the hidden line removal algorithm improves by a constant factor but the asymptotic complexity remains the same. In an improved approach both 2-d and 3-d bounding boxes were created for each part and face in the model of Fig. 1, with 2-d bounding boxes being used for edges. The resulting five level hierarchy of boxes resulted in a reduction of complexity to $O(n^{1.45})$. Nevertheless, as the size of models becomes large, a hidden line algorithm may require an unacceptably long time to run.

There exists in the literature several algorithms for finding the intersection of 2-d or 3-d boxes such as, by example, algorithms discussed by F.P. Preparata and M.I. Shamos in "Computational Geometry: An Introduction", Springer Verlag (1985). However, it has been found that actual implementations of these algorithms exhibit several weaknesses.

In U.S. Patent 4,594,673, June 10, 1986, Holly et al. describe a hidden surface processor that sorts linked lists of data wherein data is said to be inserted into the lists according to a magnitude of a scan line segment starting coordinate. As a result the sorted arrangement is based on the values of a single variable. Other sorting methods based upon a single parameter are also known in the art. However, this and other known techniques do not provide for sorting k-dimensional (k-d) boxes whose order is determined by the interplay of all of the dimensions of the box.

Thus, for 2-d boxes the overlapping of boxes is conventionally determined only by some reference point on the boxes such as by the position of a corner of the boxes. What the prior art does not teach is the sorting of k-d boxes where the order is not only determined by some reference point but also upon other attributes such as a relationship between the heights and widths of the boxes.

J.L. Bentley in a journal article entitled "Multidimensional binary search trees used for associative searching", Communications of the ACM, Vol. 18 (1975), pp.509-517 develops a multidimensional binary search tree (k-d tree) as a data structure for storage of information to be retrieved by associative searches. The specific examples regarding implementations of the k-d tree structure provided by Bentley relate to a terminal-oriented information retrieval system and to speech recognition.

It is thus an object of the invention to provide a method for spatially sorting geometric objects for efficient response to queries.

It is another object of the invention to provide a method of processing geometric objects that constructs a multidimensional tree data structure.

It is another object of the invention to provide a method employed for displaying geometric objects that constructs a multidimensional tree data structure amenable to being rapidly and efficiently searched.

It is a further object of the invention to provide a method that constructs a multidimensional tree data structure from geometric objects to be displayed and that reduces the complexity of a hidden line removal algorithm.

These objects of the invention are accomplished by the features of the main claims. Further advantages of the invention are characterized in the subclaims.

The foregoing problems are overcome and the objects of the invention are realized by a method that constructs a binary tree data structure associated with bounding boxes of geometric objects. A k-dimensional bounding box has k pairs of minimum and maximum bounds, one pair of bounds for each dimension. A median value is found for all the values of the first bound of the bounding boxes. Next, each bounding box having its corresponding bound less than this median is placed on a first sub-tree and each bounding box having its corresponding bound greater than this median is placed on a second sub-tree. At the root node are placed the maximum value for that dimension of all the bounding boxes in the first sub-tree and the minimum value for that dimension of all the bounding boxes in the second sub-tree. The boxes assigned to the first sub-tree and to the second sub-tree are similarly processed using the second bound for that dimension. This process continues in the same way on the resulting subtrees with the bounds for the remaining dimensions and repeats itself until a binary tree data structure is generated wherein the leaves of the tree are the sorted bounding boxes.

A further aspect of the invention relates to searching the binary tree data structure in response to a query. In response to, for example, a query box Q finding all of the boxes that could overlap Q begins by comparing the bounds of Q's first dimension with the first sub-tree's maximum value and the second sub-tree's minimum value as stored in the root. These comparisons determine if further searching should be carried out on the first sub-tree, the second sub-tree, or on both sub-trees. Since both these sub-trees were partitioned relative to the same first dimension, searching them continues in an identical way as the searching made at the root of the tree. Searching continues with the next dimension in the same manner at the next two levels of the tree, progresses through all the dimensions at subsequent levels, and repeats as required restarting with the first dimension until the leaves of the tree are reached.

The teaching of the invention is applicable to determining an interaction between geometric objects such as a determination of an intersection of points, edges, faces or any property amenable to having a bounding box associated therewith. By example, the invention can be employed when modeling VLSI devices to determine electrical interactions between different regions of the device. The teaching of the invention may also be employed when comparing, for example, edges to faces to determine if an overlap exists. The teaching of the invention may also be employed to determine if objects overlap when constructed with various tolerances and can further be employed to determine when, for example, projections of objects overlap and not necessarily the objects themselves.

The above set forth and other features of the invention are made more apparent in the ensuing Detailed Description of the Invention when read in conjunction with the attached Drawing, wherein:

Fig. 1A illustrates an output from a solid modelling program displayed in hidden line mode;

Fig. 1B illustrates a portion of the output of Fig. 1A and further shows bounding boxes associated with two of the edges;

Fig. 2 illustrates a hardware embodiment of a data processing system suitable for practicing the method of the invention;

Fig. 3 illustrates an example of sets of intervals upon a line and a query interval associated therewith;

Fig. 4 illustrates the tree data structure for the intervals of Fig. 3 constructed by the method of the invention;

Fig. 5 illustrates in table form information from the tree data structure (Fig. 5A) and information from the corresponding sorted data (Fig. 5B) for the example shown in Figs. 3 and 4; and

Fig. 6 is a graph illustrating the performance of a hidden line removal algorithm run with and without the method of the invention.

DETAILED DESCRIPTION OF A PREFERRED EMBODIMENT OF THE INVENTION

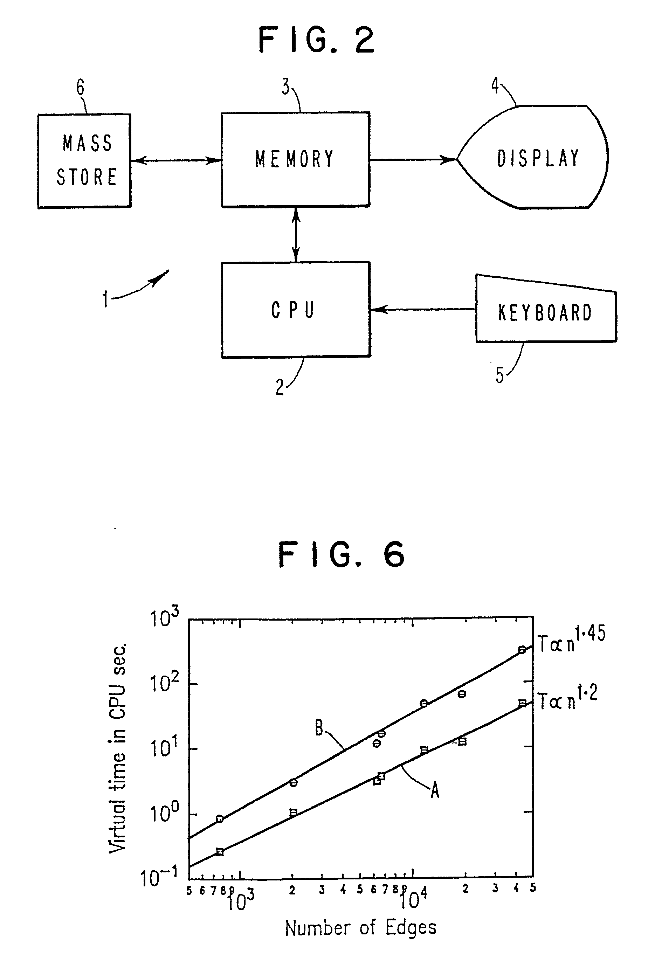

Referring to Fig. 2 there is shown an illustrative data processing system 1 that is suitable for practicing the method of the invention. System 1 includes a Central Processing Unit (CPU) 2 that is bidirectionally coupled to a read/write memory 3. Memory 3 contains storage locations for storing instructions executed by the CPU 2 including instructions for performing the method of the invention. Memory 3 also includes storage locations for storing data structures and other data generated by CPU 2. Memory 3 further includes storage locations coupled to a display 4. Display 4 displays a two dimensional representation of geometric objects, the representation being stored within the associated storage locations of the memory 3. System 1 further includes a data entry device such as a keyboard 5 whereby an operator is enabled to interact with the system 1. A mass storage device 6 is coupled to the memory 3 and provides off-line storage of data and instructions. Mass storage device 6 typically includes a magnetic storage medium such as a Winchester-type disk. One suitable system realizing the embodiment shown in Fig. 2 is a 3-d solid modeling design system, such as the aforementioned GDP, run on an IBM mainframe such as a 3090 having an IBM 5080 graphics display system coupled thereto. It should be realized though that the teaching of the invention is not to be construed to be limited for use in any one given type of software and/or hardware environment.

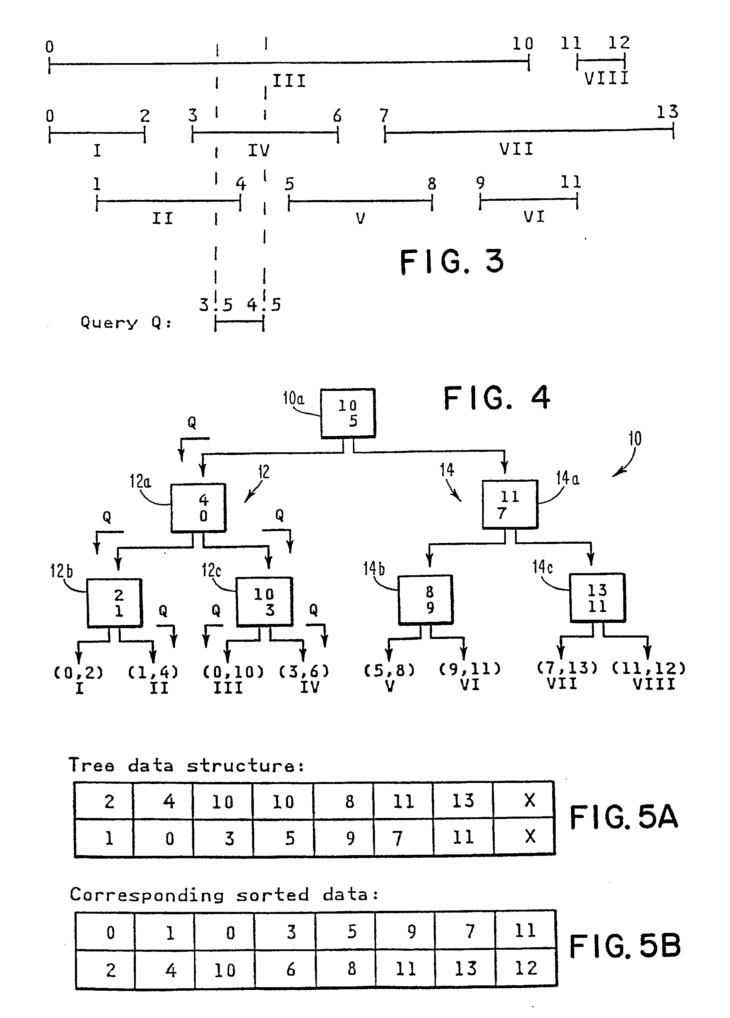

Turning now to a description of the method of the invention reference will first be made to a k-d tree data structure. The tree data structure is best explained by first considering the relatively simple example of a set of intervals on a line as shown in Fig. 3. In accordance with an object of the invention the intervals are preprocessed such that when it is required to determine a subset of intervals which overlap with a given query interval the answer is efficiently determined.

As shown in the example of Fig. 3 there is considered a set of eight line intervals, spread over three lines for clarity. The values of the endpoints of each of the intervals are shown above the intervals; the eventual sorted order is shown below in Roman numerals. Fig. 3 can be considered to illustrate unsorted data as it is presented to the method of the invention. Fig. 5A illustrates the data structure that is used to represent the tree of Fig. 4 whereas Fig. 5B, illustrates the sorted data provided by the method.

In accordance with an aspect of the invention a binary tree data structure 10, shown in Fig. 4, is constructed from the intervals as follows. First, there is found a median (X) of all of the left endpoints of the intervals. Next, all of the intervals beginning to the left of X are placed on a left sub-tree 12 of tree root 10a and all the intervals beginning to the right of X are placed on a right sub-tree 14 of the root 10a. At the root 10a are placed values, here 10 and 5, that represent the maximum of the values in the left sub-tree 12 and the minimum of the values in the right sub-tree 14, respectively. The intervals assigned to the left sub-tree 12 and to the right sub-tree 14 are similarly processed using a next coordinate, that is, the right endpoints of the intervals as opposed to the left endpoints. Repeated application of this technique, alternating between determining the medium of the left endpoints and the right endpoints, results in the creation of a binary tree as shown. The resulting sorted data array is equivalent to the leaves of the tree 10 as shown in Fig. 5B with Fig. 5A containing the minimum and the maximum values for all of the sub-trees. As will be seen, the simplicity of the resulting binary tree data structure is a significant advantage when the data structure is searched in response to a query.

A further aspect of the invention relates to searching the binary tree data structure 10 in response to a query (Q) interval. In the example shown the Q interval has a left endpoint value of 3.5 and a right endpoint value of 4.5. In response to the Q interval all of the intervals that overlap the Q interval are found by comparing the left endpoint value of the Q interval (3.5) with the left sub-tree's maximum (10) and comparing the right endpoint value of the Q interval (4.5) with the right sub-tree's minimum (5). As was previously stated the left sub-tree's maximum value and the right sub-tree's minimum value have been previously stored at the root 10a. This comparison generates information specifying if further search should be carried out on the left sub-tree 12, the right sub-tree 14 or on both sub-trees.

For the example illustrated the left endpoint of the Q interval is less than the left sub-tree's maximum value (3.5 < 10) but the right endpoint of the Q interval is not greater than the right sub-tree's minimum value (4.5 < 5). As a result the right sub-tree 14 is rejected and the search is constrained to the nodes of the left sub-tree 12. At the child node 12a the left endpoint of the Q interval is found to be less than the left sub-tree's maximum value (3.5 < 4) and the right endpoint of the Q interval is greater than the right sub-tree's minimum value (4.5 > 0). As a result the search continues at both the left sub-tree 12b and the right sub-tree 12c as referenced to the child node 12a. At the child node 12b the left endpoint of the Q interval is found to be not less than the left sub-tree's maximum value (3.5 > 2) but the right endpoint of the Q interval is greater than the right sub-tree's minimum value (4.5 > 1). As a result the search continues at the right sub-tree as referenced to the child node 12b. At the child node 12c the left endpoint of the Q interval is found to be less than the left sub-tree's maximum value (3.5 < 10) and the right endpoint of the Q interval is greater than the right sub-tree's minimum value (4.5 > 3). As a result the search continues at both the left and the right sub-trees as referenced to the child node 12c. All three of the remaining determinations occur at the leaves of the tree 10 and a determination of all of those intervals that overlap the Q interval, specifically intervals II, III and IV, is made.

The above described method of the invention, wherein the binary tree data structure is constructed, involves determining the median of endpoints of a set of intervals for each node. This is best accomplished using a quick sort-like median finding algorithm, and the expected time of the preprocessing step is typically O(n log n). Fig. 6 is a graph illustrating the performance of a hidden line removal algorithm run with, line A, and without, line B, the method of the invention, the graph being a plot of virtual CPU time

Analogous to the example of Fig. 4, for a 2-d object the node 10a is associated with the left side of bounding boxes, nodes 12a and 14a with the right sides and nodes 12b, 12c, 14b and 14c with the bottoms. An additional level of 16 child nodes (not shown) is required to represent the tops of the 2-d bounding boxes. As such, the bounds are cycled through to construct the binary tree data structure until solitary bounding boxes represent the leaves of the tree.

That is, the method constructs a binary tree data structure associated with bounding boxes of geometric objects to determine interactions between geometric objects. Construction begins at the root node by finding a median value X for all the values of the first bound, or first dimension, of the bounding boxes, such as a median value for all the left sides of the bounding boxes. Next, each bounding box having its corresponding bound less than X is placed on a first sub-tree, such as the left sub-tree of the tree root. Each bounding box having its corresponding bound greater than X is placed on a second sub-tree, such as the right sub-tree of the tree root. These two sub-trees form the second level of the tree. At the root node are placed the maximum value of the first dimension's maximum bounds from the bounding boxes in the first sub-tree and the minimum value of the first dimension's minimum bounds from the bounding boxes in the second subtree. The boxes assigned to the first sub-tree and to the second sub-tree are similarly processed using the second bound for the first dimension. This process continues in the same way on the resulting sub-trees with the bounds for the remaining dimensions. If there are more bounding boxes than can be sorted in one usage of the bounds of all the dimensions then the sorting of the resulting subtrees resumes with respect to the first bound of the first dimension, continues through the bounds of all the dimensions, and repeats in this manner until the process results in the generation of a binary tree data structure wherein the leaves of the tree are the sorted bounding boxes.

The method of the invention differs from the teaching of Bentley referred to above in the journal article entitled "Multidimensional binary search trees used for associative searching", Communications of the ACM, Voi. 18 (1975) in that Bentley stores in the nodes of his k-d tree structure what the method of the invention stores in the leaves, that is the sorted data. The method of the invention stores in the nodes of the binary tree the limits of the left and the right sub-trees, thereby greatly facilitating the search of the tree in response to a query interval or a query box. As such, it is believed that the teaching of Bentley is less efficient than the method of the invention for sorting and searching geometric objects.

A further aspect of the invention relates to searching the binary tree data structure in response to a query. In response to, for example, a query box Q finding all the boxes that could overlap Q begins by comparing the minimum bound for the first dimension of Q with the first sub-tree's maximum value and the maximum bound for the first dimension of Q with the second sub-tree's minimum value, as stored in the root. If the minimum bound of Q is less than the first sub-tree's maximum value then further searching must be carried out on the first sub-tree. If the maximum bound of Q is greater than the second subtree's minimum value then further searching must be carried out on the second sub-tree. Thus, these tests determine if further searching must be carried out on the first sub-tree, the second sub-tree, or on both sub-trees. The searching tests at the nodes of these sub-trees are identical to the tests made at the root of the tree. This is so despite the fact that these sub-trees were sorted relative to the maximum bound for the first dimension, since the minimum and maximum values stored at these nodes are independent of the bound used to sort them. They depend only on the dimension that the bound delimits. Searching continues with the second dimension in the same way at the third and fourth levels of the tree since they were sorted relative to the second dimension. Searching at subsequent level is performed relative to the dimension that controlled the sorting at that level, and continues until the leaves of the tree are reached. The bounding boxes at the leaves of the tree identified by the search are those that can overlap the query box.

The method of the invention may be embodied in an algorithm such as that shown in Appendix A of this description. The algorithm of Appendix A is comprised of two modules; specifically a module KDsort that constructs a sorted k-d tree of boxes and a module KDseek that searches that k-d tree of boxes. The algorithm is especially robust when used with a floating point number system. The algorithm employes an array of known size thus allowing space for the array within the memory 3 to be preallocated. Furthermore, the total required memory space is not large, being no more than approximately twice the space required to store the original data relating to the box coordinates. The algorithm is readily incorporated into existing programs, such as hidden line removal, without requiring significant changes in program logic.

As was previously stated the spatial sorting provided by the method of the invention is applicable to other than hidden line removal applications and may be employed for other applications where the overlap of a plurality of objects is required to be determined. By example, other applications include geometric Merge algorithms, high-quality Rendering algorithms and interference checkers.

Various modifications could be made to the method of the invention without departing from the scope and spirit of the invention. By example, the left sub-tree could be employed to store the maximum limits of further sub-trees while the right sub-tree is employed to store the lower limits in a manner opposite to that disclosed above.

## Claims

1. A computer program controlled method of determining an interaction between geometric objects comprising an initial step of sorting the objects by constructing a binary tree data structure expressive of information relating to bounds of the geometric objects.

2. A method as set forth in Claim 1 wherein the step of sorting the objects is accomplished, for a given pair of bounds of each of the geometric objects, by the steps of:

determining a median value of a minimum bound value of each dimension of the objects;

assigning to a first sub-tree of the binary tree all objects having a minimum bound value that is less than the median value;

assigning to a second sub-tree of the binary tree all objects having a minimum bound value that is greater than the median value;

storing at a root node of the binary tree a value representative of a maximum value of all of the bound values assigned to the first sub-tree; and

storing at a root node of the binary tree a value representative of a minimum value of all of the bound values assigned to the second sub-tree.

3. A method as set forth in Claim 2 wherein the steps of determining a median value, the first and the second steps of assigning and the first and second steps of storing are accomplished a plurality of times with successive bounds and repeating as required until the leaves of the tree are reached.

4. A method as set forth in Claim 3 and further comprising a step of searching the binary tree data structure to determine which one or ones, if any, of the geometric objects overlap a bound or bounds associated with a query.

5. A method as set forth in Claim 4 wherein the step of searching includes the steps of

comparing a minimum bound of the query to the first sub-tree's corresponding maximum bound value;

comparing the maximum bound of the query to the second sub-tree's corresponding minimum bound value; and as a result of the first and the second steps of comparing

specifying if further searching is carried out only on the first sub-tree, only on the second sub-tree or on both the first and the second sub-trees.

6. A method as set forth in Claim 5 wherein the first and the second steps of comparing and the step of specifying are repetitively accomplished for specified sub-trees of the binary tree until the leaves of the tree are reached.

7. A computer program controlled method for preprocessing bounding boxes of geometric objects to facilitate a determination of their overlap, comprising the steps of:

constructing a binary tree data structure by determining a median value of a bound value of a dimension associated with each bounding box;

assigning to a first sub-tree of the binary tree data structure all bounding boxes having a corresponding minimum bound value that is less than the median value;

assigning to a second sub-tree of the binary tree data structure all bounding boxes having a corresponding minimum value that is greater than the median value;

storing at a root node of the binary tree data structure a value representative of a maximum value of all corresponding values of the bounding boxes assigned to the first sub-tree; and

storing at a root node of the binary tree data structure a value representative of a minimum value of all corresponding values of the bounding boxes assigned to the second sub-tree.

8. A method as set forth in Claim 7 wherein the steps of determining a median value, the first and the second steps of assigning and the first and second steps of storing are accomplished for each node of each of the sub-trees of the binary tree data structure.

9. A computer program controlled method of determining an overlap between geometric objects comprising the steps of sorting the objects by constructing a binary tree data structure expressive of information relating to the bounds of the geometric objects, the binary tree data structure including at least a first and a second sub-tree; and searching the binary tree data structure to determine which one or ones, if any, of the geometric objects overlap a bound or bounds associated with a query, wherein the step of searching includes the steps of:
comparing a minimum bound associated with the query to a first sub-tree's corresponding maximum bound value;
comparing a maximum bound associated with the query to a second sub-tree's corresponding minimum bound value; and as a result of the first and the second steps of comparing
specifying if further searching is carried out only on the first sub-tree, only on the second sub-tree or on both the first and the second sub-trees.

10. A method as set forth in Claim 9 wherein the first and the second steps of comparing and the step of specifying are repetitively accomplished for specified sub-trees of the binary tree until the leaves of the binary tree are reached.

11. A method as set forth in Claim 9 wherein the step of sorting is accomplished, for a given pair of bounds of each of the geometric objects, by the steps of:
determining a median value of a minimum bounding value of each dimension of the objects;
assigning to the first sub-tree of the binary tree all objects having a corresponding minimum bounding value that is less than the median value;
assigning to a second sub-tree of the binary tree all objects having a corresponding minimum coordinate value that is greater than the median value;
storing at a root node of the binary tree a value representative of a maximum bounding value of all of the objects assigned to the first sub-tree; and storing at a root node of the binary tree a value representative of a minimum bounding value of all of the objects assigned to the second sub-tree.

12. A method as set forth in Claim 11 wherein the steps of determining a median value, the first and the second steps of assigning and the first and second steps of storing are accomplished for each node of each of the sub-trees of the binary tree.

## APPENDIX A

```
routine KDSort:
parameters:
     both input & output:
          (*,dimension,2) array of coordinate pair bounds of closed boxes
          matching array of structures for subtree bounds:
               a. max bound of subtree to left of NODE index
               b. min bound of subtree to right of NODE index
               c. pointer to other unused boxing data
     input only:
          index of the last box in the array
initialize:
     DIM to 1 for left coordinate of first dimension
     SIDE to 1 for left side of coordinate bound
     START to starting index of input array to be sorted, i.e. 1
     STOP to ending index of input array to be sorted, (parameter)
     a stack of subtrees to be sorted to null
do until the initial tree and each subtree on the stack has been sorted
     if the current subtree is not sorted, i.e. STOP > START
          then do
               set NODE to the midpoint index of the subtree
               call SELECT to sort subtree
               if the left subtree is not null then put it on the stack
               make the right subtree the current subtree. i.e. set START = NODE + 1
          end then do
          else pull the next subtree off the stack
     update SIDE and DIM to next coordinate/bound
end do until


internal subroutine SELECT:
initialize LEFT and RIGHT to START and STOP indices of subtree
do while the subtree is not null, i.e. LEFT < RIGHT
     set X to the box value at the current NODE, DIM, and SIDE
     set LEFTPASS = LEFT, RIGHTPASS = RIGHT
     do until the LEFTPASS exceeds the RIGHTPASS
          increment LEFTPASS to the first index whose box value is > = X
          decrement RIGHTPASS to the first index whose box value is < = X
          if part of subtree between LEFTPASS & RIGHTPASS, (LEFTPASS < RIGHTPASS)
               then do
                    swap the LEFTPASS and RIGHTPASS array elements
                    swap the pointers of the other LEFTPASS and RIGHTPASS data
               end then do
          if LEFTPASS = RIGHTPASS then increment LEFTPASS and decrement RIGHTPASS
     end do until
     if RIGHTPASS < NODE then decrease remaining subtree by setting LEFT = LEFTPASS
     if NODE < LEFTPASS then decrease remaining subtree by setting RIGHT = RIGHTPASS
end do while
determine the maximum (DIM,2) value of the subtree to the left of NODE
determine the minimum (DIM,1) value of the subtree to the right of NODE
```

YO 989 079

8

```
routine KDSeek:
Parameters:
    input:
        (*,dimension,2) array of coordinate pairs bounding closed boxes
        matching array of structures for subtree bounds:
            a. max bound of subtree to left of NODE index
            b. min bound of subtree to right of NODE index
            c. pointer to other unused boxing data
        QUERY box (open set to eliminate touching cases)
        size of closed boxes array
    output:
        array of indices whose boxes overlap the QUERY box
        size of overlapping boxes array

initialize the stack of subtree to be searched to null
do until the initial/current tree and the stack of subtrees have been searched
    if the current subtree is small
        then do
            compare each box in the subtree to the QUERY box
            if the boxes overlap then record the overlapping box
            pop the next subtree off the stack
            goto NextSearch
        end then do
    consider the subtree divided at its middle into left and right subtrees
    if the QUERY box could overlap some boxes of the left subtree
        then if the QUERY box also could overlap boxes of the right subtree
            then push the left subtree on the stack
            else update the current subtree to be the left subtree
        else update the current subtree to be the right subtree
    NextSearch:
    update the indicies for the next dimension/side of the boxes
end do until
```

9

# FIG. 1A

# FIG. 1B

# F I G. 2

# F I G. 6

FIG. 3

FIG. 4

Tree data structure:

| 2 | 4 | 10 | 10 | 8 | 11 | 13 | X |
|---|---|----|----|---|----|----|---|
| 1 | 0 | 3  | 5  | 9 | 7  | 11 | X |

FIG. 5A

Corresponding sorted data:

| 0 | 1 | 0  | 3 | 5 | 9  | 7  | 11 |
|---|---|----|---|---|----|----|----|
| 2 | 4 | 10 | 6 | 8 | 11 | 13 | 12 |

FIG. 5B